# EUROPEAN PATENT APPLICATION

(11) **EP 0 697 228 A1**
(43) Date of publication of application: **21.02.1996**
(21) Application number: 94113370.4
(22) Date of filing: 26.08.1994
(51) Int. Cl.: A63B 69/38

(54) **Article for the play of tennis**

(30) Priority: 18.07.1994 IT MI941493
(71) Applicant: Tammaro, David, I-20129 Milan (IT); Rimoldi, Augusto Luigi, I-20015 Parabiago (MI) (IT)
(72) Inventor: Tammaro, David, I-20129 Milan (IT); Rimoldi, Augusto Luigi, I-20015 Parabiago (MI) (IT)

(57) **Abstract**

The invention labelled as a whole with (1) in figure 1, concerns the transformation of a normal tennis racket into an opto-electro-acoustic device useful for playing tennis.
This article is able to give in real-time, without reducing any of the racket perfomances, exact informations on the right position of the ball impact on the stringing pattern area (4) of the racket (2).
The opto-electro-acoustic circuit (3) which essentially is the monitoring system, includes sensor couples (8): the transmitter (13) and the receiver (14) located into the frame head (15). The sensors layout is designed with the purpose of subdividing the stringing pattern area (4) into several regions (s).
The circuit (3) emits different acoustic signals depending on which region (or regions) the impact between the ball and the stringing pattern area (4) occurs.

## Description

The present invention relates to a new article for the play of tennis. In the play of tennis it is at the same time both fundamental and difficult the fact that the player has to hit the ball in the right way. That means hitting the ball with the maximum power and precision.
The easiest way in order to sutisfy both the previous mentioned conditions is to hit the ball within the central zone of the hitting area of the string pattern of the racket head which is defined by the experts as the "power zone".
Therefore it comes out the need of beeing able to use means which guaranty immediate, exact and unquestionable information about the impact-point between the ball and the hitting area.
The aim of the present invention is to provide both trainers and trainees with the above mentioned means in order to make easier and worthier the learning experience of playing tennis.
These means are all contained in the article for the play of tennis as claimed in Claim 1.

The basic idea of the invention is to provide the traditional tennis racket with opto-electro-acoustical features in order to reach the desired localization informations about the impact-point between the ball and the hitting area with immediate and unquestionable precision.
In accordance with the invention, the following targets have been accomplished:
- optimum optical power coupling between the sensors : transmitter and receiver;
- minimum size and weight of the power-supply unit;
- maximum efficiency of the opto-electro-acoustic circuit for optimum battery-lasting;
- fully portability, easy battery replacement and reperibility;
- reliability;
- maximum simplicity and essentiality in the design;
- shocks, vibrations and other external agents resistant;
Figures and drawings here enclosed are only explanatory examples and not limitations for the invention.
Figure 1 is a schematic front view of the article as an invention in its globality.
Figure 2 is a partial view a section along the line II of figure 1.
Figure 3 is a section along the line III -III of figure 2.
Figure 4 is a view along the line IV of figure 3.
Figure 5 is a flowchart of the opto-electro-acoustic circuit.

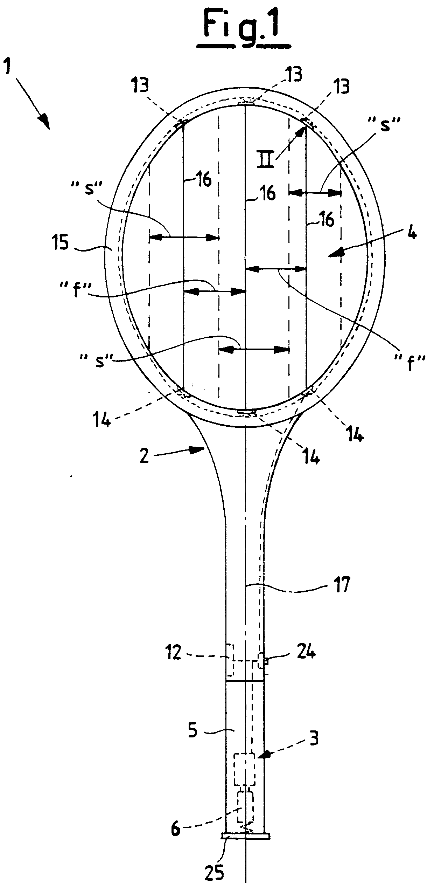

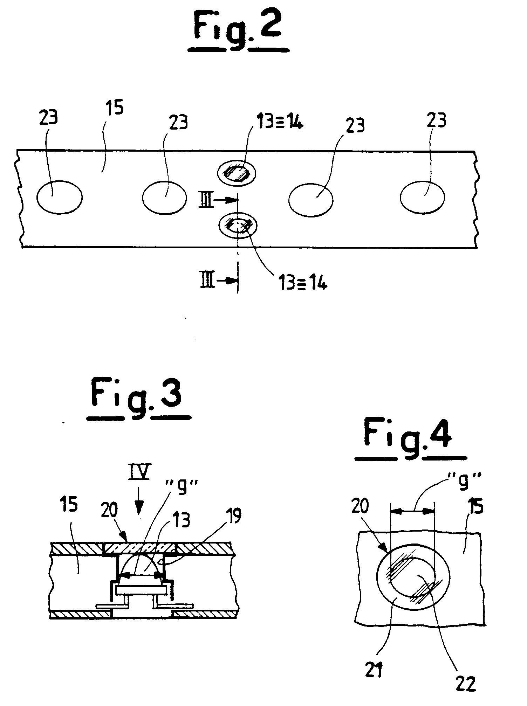

Referring to the above mentioned figures, the article for the play of tennis as an invention, labeled in a generic way as 1, includes a tennis racket 2 and an opto-electro-acoustic circuit 3.
The racket 2 is by itself traditional and its components are the frame head 15, the stringing pattern 4 and the handle 5.
Generally, both the frame head 15 and the handle 5 have an empty cavity in their inner part where the components of the opto-electro-acoustic circuit can be embedded.
In order to make figure 1 more understandable we do not show in that figure the stringing pattern.
The stringing of the racket is anyway a very well known and traditional process which uses the holes 23 in figure 2. The holes are placed in the frame head 15.

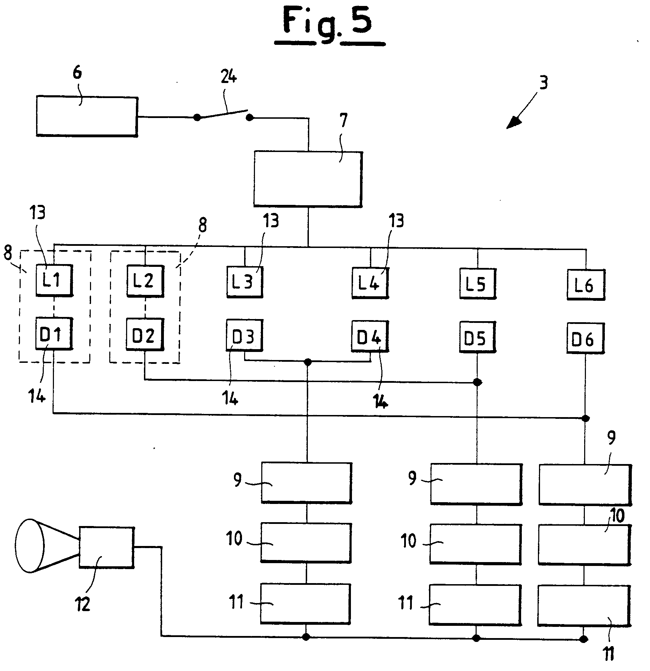

Specifically referring to figure 5, the opto-electro-acoustic circuit 3, includes essentially a power supply unity 6, connected through a switch 24 to a signal generator 7. The signal generator 7 is connected ( or better drives) several couples of optical sensors 8 ( in the example that we are going to describe, we use six couples). The couples of optical sensors 8 are connected via their respective front-end circuits 9 to digital threshold circuits 10 . The digital threshold circuits are connected ( or better act ) on several units 11 which generate electric signals at several acoustical frequencies and are connected (or better drive) an acoustic transducer 12.

Units 11 and the output devices ( in this example acoustic transducers) could be replaced with different output devices such as color screens or even a transmitting signal system.
Each couple of optical sensors includes a transmitting diode, Light Emitting Diode (LED) 13 and a receiving diode , Photo Diode (PD) 14, or a photo-transistor.
In a simplified case, six LED's 13 and six PD's 14 . The first are labeled with L1-L6 and the latter with D1-D6. Both the LED's 13 and the PD's 14 are embedded in the frame head 15. They are placed at opposite locations along the junction lines 16.
Preferably these lines are parallel to the racket axis 17 of the handle 5 and at distance , let us say, "f". The distance "f" can be chosen in the range 6 to 7 cm. In that way, the stringing pattern (4) is subdivided in several monitoring areas (s).

When the article for the play of tennis 1 is switched on, each LED 13 is transmitting a moduled optical signal which is detected by the dual optical sensor: the receiver PD 14.

Three couples 8 of optical sensors are placed in the head of the racket. They all are located on one side of the plain of the stringing pattern. On the opposite side the remaining three couples are located.
Preferably, the emitting diodes 13 are located in the frame head 15 at the opposite side of the handle 5, while the receiving PD 14 are located in the bridge which closes, at the bottom, the oval in the region near the handle. In order to prevent the article for the play of tennis 1 from schocks and possible external agents, the LED's 13 and the PD's 14 are embedded into inner seats 19, inside the frame head 15.
Regarding the electric connections, as it is visible from figure 5, each PD 14 which is on one side of the stringing pattern is connected with an additional PD 14 which is on the remaining side of the stringing pattern. Both the mentioned PD 14 are connected to the same circuits 9, 10 and to the unit 11.
In our case the receiver diodes D₁ and D₆ , D₂ and D₅ , D₃ and D₄ are connected in couple.

Considering that tennis is a game usually played outdoors, it is important that the article for the play of tennis, as an invention, has to be reliable in such an environment and it is fundamental that the article 1 has to work properly even in conditions of direct and complete solar radiations.
In such a condition common infrared PD's, working in the 800-900 nm, spectral range are fully saturated ( made "blind") by solar radiations, and they cannot detect the optical signal emitted by the LED's. In order to solve this problem one could use opto-electronic devices whose working wavelength is in the 2800-3400 nm spectral window. In fact at such wavelengths, the solar radiation at the earth surface has a minimum in intensity due to the radiation absorption caused by some elements of the atmosphere.
Anyway some technical and not least commercial considerations induced us to use common PD's working in the near infrared. It was, therefore, necessary to solve the PD's saturation problem due to the solar radiations. This was possible on one hand exploiting the optical directionality properties of the LED's light beam, in comparison with the solar radiations and, on the other hand reducing the PD's acceptance corner.
In alternative one could solve the problem with an electronic filtering of the signal but such a solution, although valid in theory, could result in a bigger complexity of the electronic circuit 3 both in power consumption and in realization costs.
The exploiting of the optical directionality properties of the LED's light beam is the best solution because it does not exclude the electronic signal filtering as a complementary technique.

It was experimentally found that the best performances are obtained when the input pin-hole in correspondence of the PD's sensitive surface has a diameter "g" of 2 mm for the traditional tennis rackets head dimensions.

With such a pin-hole configuration, when LED's and the PD's are located at a distance equal to the major diagonal of the head oval, one can reach the best trade-off between spatial filtering of the solar radiation and the LED-PD optical power coupling.
An additional important aspect in the optical power coupling is the LED driving electrical signal. Maximum efficiency has been obtained with a 5 KHz signal frequency which has an "on" time equal to 1/20 of the complete signal period. Such an impulsive signal characterized by an "on" time substantially reduced with respect of the corresponding "off "time, has important vantages in terms of efficiency compared with signals which have greater "on" versus "off " time ratios.
An other important specific is that regarding weight and dimensions of the opto-electro-acoustic circuit 3.
Such a specific has been sutisfied using Surface Mounted Devices (SMD).
This technique allows a meaningful shrinking of the circuit 3 dimensions. The weight of the cicuit 3 as shown in figure 5 does not exceed 15 gramms, and it is contained in a volume with a basis of 2x6 cm² and 6-7 mm in height. Taking into consideration that this circuit is power supplied with a 9 Volt battery whose weight is about 35 gramms, the addition in weight when the article is completely mounted is less than 50 gramms. In fact, the original amount in weight is reduced by removing large part of the balancing plumb located inside the handle which is replaced with the electronic components.
For balancing reasons the circuit 3 is embedded in the handle 5, allowing the player to substitute the battery, just removing the plastic cap 25 at the butt end of the handle 5.
Another important specific is the electronics low power consumption. Just to give an idea, it is considerably reasonable a power consumption quantifed by some hours of continous working when the circuit 3 i supplied by a commercial 9 Volt battery. Such a specific has been fullfilled using
C-MOS technology devices whose power consumption is much lower than the analogous MOS devices.
In order to make the article 1 more reliable, the LED's 13 and the PD's 14 can be protected with plastic screens 20 (figure 3 and 4) transparent to the emitting wavelength of the LED's.

## Claims

1. Article for the play of tennis (1) having one handle (5), one frame head (15) and a stringing pattern area (4), is characterized by beeing equipped with an opto-electro-acoustic circuit (3) including several optical sensors couples (8). Each couple has an optical transmitter (13) - Light Emitting Diode (LED) - plus an optical receiver sensor (14) - Photo Diode (PD) , located into the frame head (15) facing each other on opposite sides of the racket head oval and dividing the stringing pattern area in several monitoring areas (s). Each LED (13) is able to emit a modulated optical signal which can be detected by the corresponding PD (14). Each optical sensor couple (8) is part of the opto-electro-acoustical circuit (3) which is able to produce sounds, through an acoustical transducer (12) due to the interruption of the optical beam connecting each of the above mentioned optical sensors couple (8).

2. Article as claimed in Claim 1, characterized by the fact that the output unit (12) is a loudspeaker, or a buzzer, or a color screen, or a signal transmitter.

3. Article for the play of tennis as claimed in Claim 1, characterized by the fact that the optical sensor couples (8) are located at opposite sides of the stringing pattern plane (4).

4. Article for the play of tennis as claimed in Claims 2 and/or 3, characterized by the fact that the optical sensors of each couple (8) are placed in such a way that the junction lines (16) , also called optical paths are parallel to the racket axis (17) and separated by a quantity (f) whose value can be between 6-7 cm.

5. Article for the play of tennis as claimed in Claim 1, characterized by the fact that it includes three optical sensors couples (8) for each side of the stringing pattern.

6. Article for the play of tennis as claimed in Claim 1, characterized by the fact that each optical sensor couple (8) includes one optical emitter (LED) (13) and an optical detector (PD) (14), embedded into seats (19) inside the frame head (15).

7. Article for the play of tennis as claimed in Claim 1, characterized by the fact that the LED's working wavelength is in the infrared and are fed by a 5 KHz impulsed signal with an "on" time equal to 1/20 of the whole signal period and that the optical sensors receivers (14) are associated with an optical filter screen (20) capable of both giving protection and operating a selection of the working spectral window.

8. Article for the play of tennis as claimed in Claim 6, characterized by the fact that the optical filter screens (20) have an external circular crown region which is opaque to the LED's wavelength emission and an internal circular region (22) transparent to the LED's emission radiation.

9. Article for the play of tennis as claimed in Claim 7, characterized by the fact that the inner region of the circular region (22) transparent to the LED's emission radiation has a diameter (g) of the input pin-hole on the PD's sensitive surface of 2 mm.

10. Article for the play of tennis as claimed in Claim 1, characterized by the fact that the opto-electro-acoustical circuit (3) is capable of detecting an interruption of the light beam of each couple (8) of optical sensors signaling it with a sound which has different characteristics for each couple (8) of such optical sensors, includes:
- Optical transmitting sensors (13) driven by a signal generator (7) whose power supply unit is an electrical battery;
- Optical receiving sensors (14) electrically connected two by two to an interface circuit (9), a threshold logical circuit (10) and one electrical unit for the generation of the output acoustical signals, or for the generation of signals driving an attacched or/and remote color (monochromatic) screen or for transmitting signal to any other remote device for output displaying. The two by two receivers (D₁ and D₆, D₂ and D₅, D₃ and D₄) are located on opposite sides regarding with the stringing pattern plane.

11. Article for the play of tennis as claimed in Claim 1, characterized by the fact that the cicuit (3) is embedded into the handle (5) with the feature of an easy battery (6) replacement removing the butt end cap (25).

12. Article for the play of tennis as claimed in Claim 10, characterized by the fact that the circuit (3) has surface mounting devices (SMD).

13. Article for the play of tennis as claimed in Claim 10, characterized by the fact that the circuit (3) has electronic components base on C-MOS technology.

14. Article for the play of tennis as claimed in Claim 10, characterized by the fact that the circuit (3) has a weight which does not exceed the 15 gramms, (battery not included) and covers a volume with about 2x6 cm² basis and 6-7 mm in height.

15. Article for the play of tennis as claimed in Claim 9, characterized by the fact that this circuit is power supplied with 9 volt battery.

16. Article for the play of tennis as claimed in one or more of the previous Claims, characterized by the fact that the LED's and the PD's are protected with plastic screens.

17. Article for the play of tennis as described and/or shown.
